# EUROPEAN PATENT SPECIFICATION

(11) **EP 3 570 320 B1**
(45) Date of publication and mention of the grant of the patent: **16.11.2022**
(21) Application number: 18172908.8
(22) Date of filing: 17.05.2018
(51) Int. Cl.: H01L 23/427, F28F 13/10, H01L 23/467

(54) **TRANSFERRING HEAT FROM A HEAT SOURCE**
ÜBERTRAGUNG VON WÄRME VON EINER WÄRMEQUELLE
TRANSFERT DE CHALEUR PROVENANT D'UNE SOURCE DE CHALEUR

(43) Date of publication of application: 20.11.2019
(73) Proprietor: Nokia Technologies Oy, 02610 Espoo (FI)
(72) Inventor: AGARWAL, Akshat, Dublin, K36 HY46 (IE); JEFFERS, Nicholas, Wicklow, A63YH63 (IE)
(74) Representative: Sayer, Robert David

(56) References cited:
- JP-A- 2008 210 876
- US-A1- 2016 260 653

## Description

### Field

This relates to transferring heat from a heat source, for example, for thermal management of an electronic device.

### Background

Components used in electronic devices typically generate waste heat which can lead to reduced performance and/or reduced reliability and, ultimately, premature failure of the devices. Thermal management techniques are used to help reduce the temperature of the components and, thus, improve the reliability of the devices. Examples for thermal management techniques include the use of heat sinks and heat pipes.

US2016/260653 discloses a semiconductor device including a substrate.

JP2008210876 discloses a cooling device for cooling an element such as a semiconductor element.

### Summary

The invention is set forth in the claims.

In a first aspect, this specification describes an apparatus comprising: means comprising a heat pipe (106) which comprises a fluid which changes phase from a liquid in a first portion thereof, due to heating, into a gas which travels to a second portion thereof, the heat pipe being configured for receiving heat from a heat source (104) at the first portion thereof and for transferring heat from the first portion to the second portion thereof, wherein the second portion is carried by a flexible substrate (108) positioned over the heat source, the flexible substrate having a free-end configured to mechanically oscillate for generating an airflow to carry the transferred heat away from the second portion whereby the gas condenses back into a liquid

The substrate may comprise or may be coupled to a piezoelectric oscillator. The substrate may be a substantially planar blade.

The heat transferring means in the second portion may comprise a plurality of branches.

The apparatus may further comprise one or more electronic components in contact with, or proximate to, the first portion.

In a second aspect, this specification describes a method comprising: receiving heat from a heat source at a first portion of a heat pipe; transferring the heat from the first portion to a second portion of the heat pipe carried by a flexible substrate over the heat source, the flexible substrate having a free-end; and mechanically oscillating the substrate free-end to generate an airflow to carry the transferred heat away from the second portion of the heat pipe.

### Brief Description of Drawings

Example embodiments will now be described by way of example only with reference to the accompanying drawings, in which:
Fig. 1 is a first example of an apparatus for thermal management of an electronic device according to example embodiments;
Fig. 2 is a cross-sectional schematic view of an example heat pipe;
Fig. 3 is a second example of an apparatus for thermal management of an electronic device according to example embodiments;
Figs. 4a, 4b and 4c show perspective views of an apparatus for thermal management in three stages of oscillation according to example embodiments;
Fig. 5 is a third example of an apparatus for thermal management of an electronic device according to example embodiments;
Fig. 6 is a perspective view of a fourth example of an apparatus for thermal management of an electronic device.
Fig. 7 is a flow diagram of showing operations that may be performed in example embodiments.
Fig 8 is a flow diagram showing a method of manufacturing an apparatus according to example embodiments.

### Detailed Description

The various aspects will be described in detail with reference to the accompanying drawings. Wherever possible, the same reference numbers will be used throughout the drawings to refer to the same or like parts. References made to particular examples and implementations are for illustrative purposes, and are not intended to limit the scope of protection.

Example embodiments relate to thermal management of an electronic device. In particular, example embodiments relate to a heat pipe configured to mechanically oscillate.

Example embodiments described relate to an apparatus for thermal management of, for example, an electronic component in order to transfer heat away from one or more electronic devices. This heat may be considered waste heat generated by one or more electronic components when operating in an electrical or electronic device.

Example embodiments provide an apparatus comprising a heat pipe that, at one portion thereof, receives heat from a heat source and transfers the heat to a second portion thereof which is configured to mechanically oscillate. The second portion thereof may therefore generate an airflow to carry the transferred heat away from the second portion. It will be appreciated that a heat pipe is an example of a heat-transfer device that involves phase transition, for example to turn a liquid into a vapour by heat absorption at a hot interface, whereafter the vapour travels along the pipe to a cold interface where it condenses back into a liquid and returns to the hot interface. Embodiments herein provide example forms of heat pipe, but are not limited to such forms.

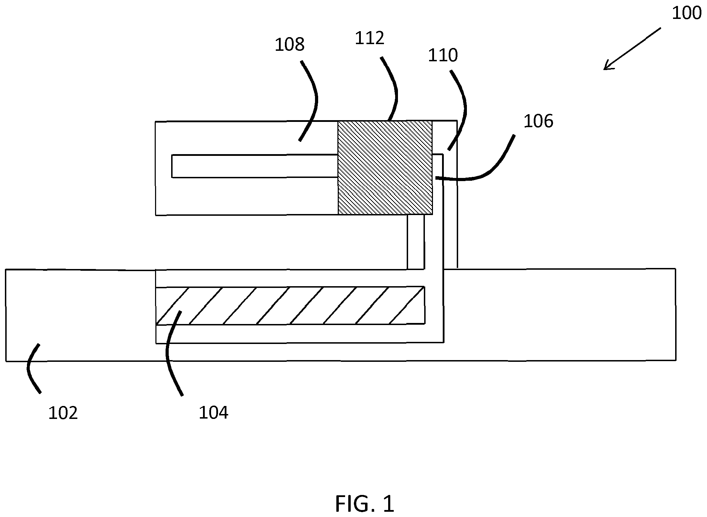

FIG. 1 shows a piezoelectric fan 100 comprising a heat pipe 106 according to example embodiments. The piezoelectric fan 100 comprises a flexible cantilever blade or beam 108 attached at one end to an upstanding and rigid or semi-rigid post 110. The beam 108 may have another suitable shape, like rounded, elliptical, or like. The opposite end of the beam 108 is able to move freely. A first end of a piezoelectric actuator 112, which may for instance be formed of a sandwich of piezoelectric materials, is attached to the post 110 and a second, opposite end of the piezoelectric actuator 112 is attached the beam 108. The post is fixed or proximate to an electronic device 102. The electronic device 102 comprises an electronic component 104. The heat pipe 106 at one end is positioned in proximity of the electronic component 104 and extends away therefrom such that its other end is on or within the blade or beam 108. In FIG. 1 the heat pipe 106 runs either side of two (upper and lower) surfaces of the electronic component 104 in the electronic device, and extends through the post 110 and through the beam 108. Other configurations are possible.

An Alternating Current (AC) voltage is applied to the piezoelectric actuator 112, which causes the piezoelectric actuator 112 to expand and contract. As the piezoelectric actuator 112 expands and contracts, the free end of the beam 108 oscillates mechanically. This causes a portion of the heat pipe 106 that runs through the beam 108 also to oscillate mechanically. The oscillations generate an airflow at the free end of the beam 108 by the movement of the surfaces of the beam against the surrounding air.

An example type of heat pipe 106 has three layers: an upper layer, a gas channel and a lower layer. The upper layer and the lower layer have a wick structure including a plurality of capillary channels. The heat pipe 106 includes a working fluid (for example, water). In the upper layer and the lower layer, the working fluid is in a liquid phase. In the gas channel, the working fluid is in a gas phase.

In use, the heat pipe 106 transfers heat from an evaporator region, which is a region near (e.g. adjacent to) the electronic component 104, to a condenser region, which is on the beam 108 and therefore more remote from the electronic component. The temperature at the evaporator region is higher than the temperature at the condenser region. At the evaporator region, the working fluid evaporates and changes phase from a liquid to a gas due to heat generated by the electronic component 104. At the condenser region, the working fluid condenses and changes phase from a gas to a liquid due to the comparatively cooler region at the free end of the beam 108. As result, heat is moved from the electronic component 104 to the condenser region on the beam 108.

The heat is conducted from the heat pipe 106 to the air in contact with the beam 108. The heat is conducted either directly from the heat pipe 106 to the air, or is conducted to the air from the heat pipe 106 via part of the beam 108 that does not form the heat pipe 106. The generated airflow causes air warmed by the heat pipe 106 and the beam 108 to be carried away from the beam 108. This also causes air that was not in contact with the beam 108 to be carried into contact with the beam 108.

The temperature of the condenser region is therefore reduced by the conduction of heat from the heat pipe 106 to the air in contact with the beam 108. As a result, the electronic component 104 is cooled and the operation and reliability of the electronic device 102 may be improved.

At the condenser region, the gas condenses back into the liquid and travels back to the evaporator region. In some types of heat pipe 106, this is through capillary action in the wick. The liquid can then change back into the gas at the evaporator region, due to heat generated by the electronic component 104. The cycle of the fluid changing phase then repeats. As a result, the electronic component 104 continues to be cooled.

The frequency of the AC voltage may be adapted to match (or nearly match) the resonant frequency of the beam 108. This causes the beam to reach its maximum deflection, which in turn generates a larger airflow compared to a beam not operating at the resonant frequency. Increasing the frequency of the AC voltage causes the piezoelectric actuator 112 to expand and contract more frequently. Put another way, increasing the AC frequency increases the oscillation frequency of the piezoelectric actuator 112, which increases the oscillation frequency of the beam 108. As a result, a larger airflow is generated.

The surface of the heat pipe 106 may be close to the surface of the beam 108. The distance between the exterior surface of the beam 108 and the chamber of the heat pipe 106, i.e. the thickness of the wall of the heat pipe 106, may be approximately 100 micrometres, or more generally be in the range of tens to hundreds of micrometres. It should be understood that the heat pipe 106 may be at the surface of the beam 108. The beam 108 may have a thickness of some hundreds of micrometres up to a thousand micrometres, e.g. 300 to 1000 micrometres.

The heat pipe may comprise multiple branches. The heat pipe 106 maybe in the proximity or in direct contact with the electronic component 104, or combination thereof. This may help to keep the thermal resistance between the heat pipe and the electronic component 104 as low as possible. For instance, the heat pipe 106 and the electronic component 104 maybe encapsulated whilst in contact with one another.

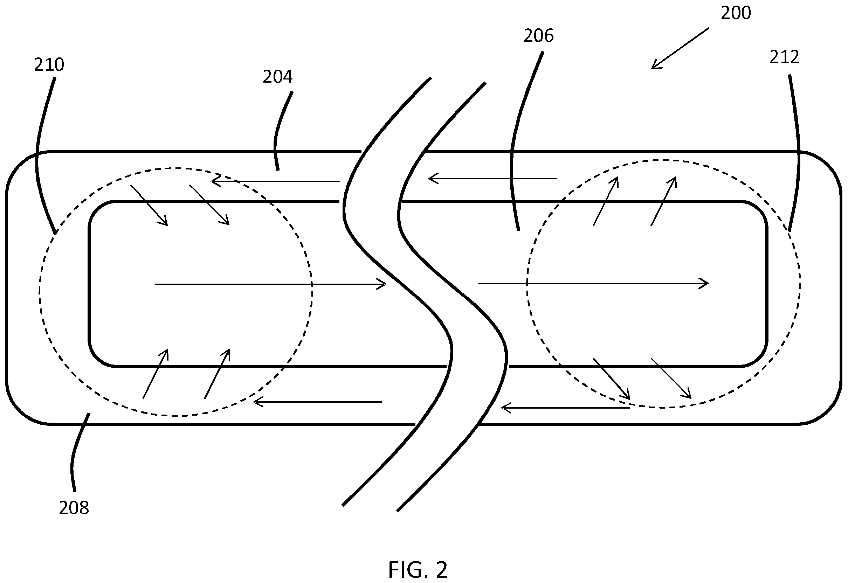

FIG.2 shows an example of heat pipe structure 200, shown in cross-section. The heat pipe 200 has three layers: an upper layer 204, a gas channel 206 and a lower layer 208. The upper layer 204 and the lower layer 208 have a wick structure including a plurality of capillary channels (not shown). The heat pipe 200 includes a working fluid (for example, water). In the upper layer 204 and the lower layer 208 the working fluid is in a liquid phase. In the gas channel 206, the working fluid is in a gas phase.

In use, the heat pipe 200 transfers heat from an evaporator region 210, to a condenser region 212. The temperature at the evaporator region 210 is higher than the temperature at the condenser region 212. At the evaporator region 210, the working fluid evaporates and changes phase from a liquid to a gas due to heat. At the condenser region 212, the working fluid condenses and changes phase from a gas to a liquid due to the comparatively cooler region at the condenser region 212. As result, heat is moved from the evaporator region 210 to the condenser region 212.

At the condenser region 212, the gas condenses back into the liquid and travels back to the evaporator region 210 through capillary action of the wick in the upper layer 204 and the lower layer 208. The liquid can then change back into the gas at the evaporator region 210. The cycle of the fluid changing phase then repeats to continuously drive gas and heat from the evaporator region 210 to the condenser region 212.

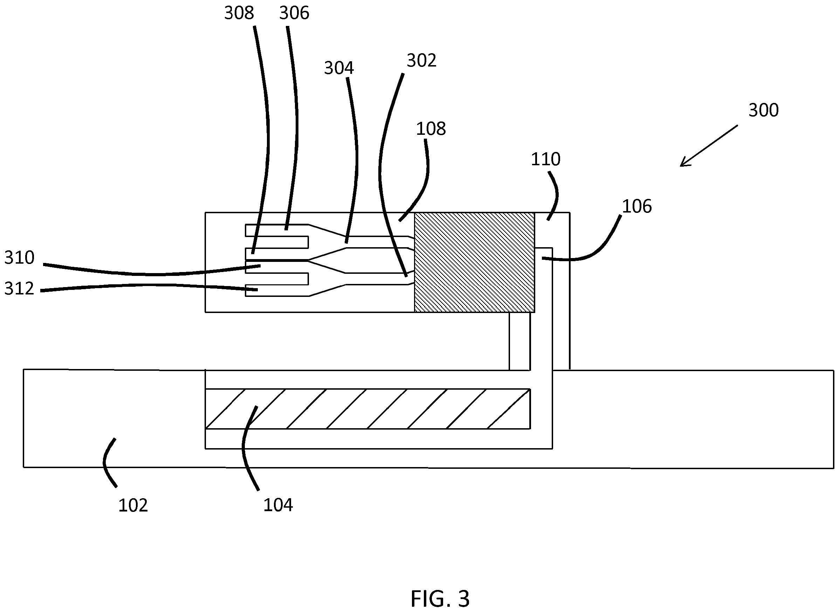

FIG. 3 shows a piezoelectric fan 300 with a heat pipe 106 according to another example embodiment. The portion of the heat pipe 106 that runs through the beam 108 is bifurcated into two branches 302 and 304. Each of the two branches 302 and 304 are bifurcated into two sub-braches 306, 308, 310 and 312. Other branching arrangements may be employed.

The branches 302 and 304 and the sub-branches 306, 308, 310 and 312 increase the surface area of the heat pipe 106 that runs through the beam 108. The increased surface area may allow the greater conduction of heat to the air surrounding the beam 108, which may cause more heat to be dissipated. Therefore, the rate of heat transfer along the heat pipe 106 may be increased. As a result, the electronic component 104 is cooled and the operation and reliability of the electronic device 102 may be improved. The branched design may distribute the heat effectively so that the generated airflow may dissipate the heat due to forced convection.

It should be understood that there may be only one or two heat pipes without any branches or sub-branches. It should also be understood that the each of branches and/or sub-branches may be bifurcated further as required. It should also be understood that the each of the branches and/or sub-branches may be divided into three or more branches.

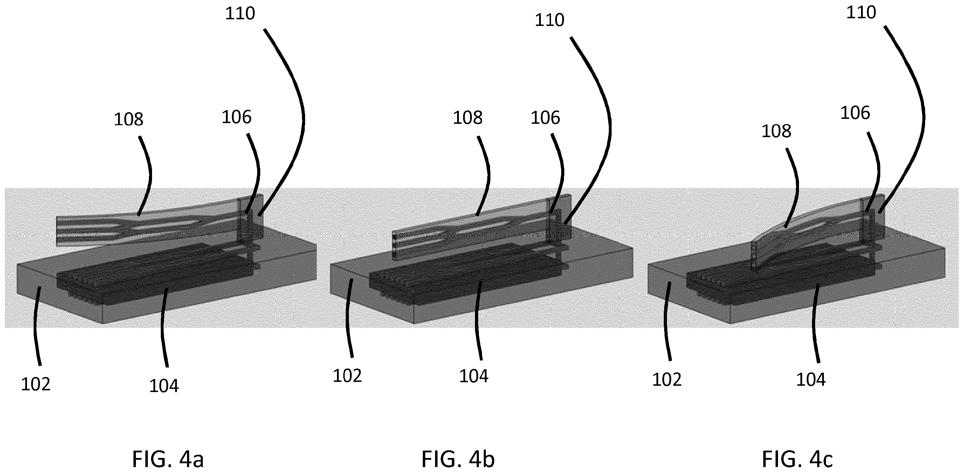

FIGS. 4a, 4b and 4c show the beam 108 at a first oscillation stage, a second oscillation stage and third oscillation stage, respectively.

The beam 108 may be driven at its resonant frequency, which causes the maximum deflection at the tip of the beam 108. The AC voltage causes the piezoelectric actuator 112 to expand and contract. FIG. 4a shows the free end of the beam 108 in a first extreme position where the piezoelectric actuator 112 is deformed in first configuration causing the beam 108 to move toward a first direction.

As the current reverses, the piezoelectric actuator 112 deforms in a second configuration causing the beam to move toward a second direction, opposite to the first direction. FIG 4c shows the free end of the beam 108 in a second extreme position. FIG. 4b shows the beam 108 in a central position.

As the piezoelectric actuator 112 continuously expands and contracts the free end of the beam 108 oscillates mechanically between the first direction and the second direction.

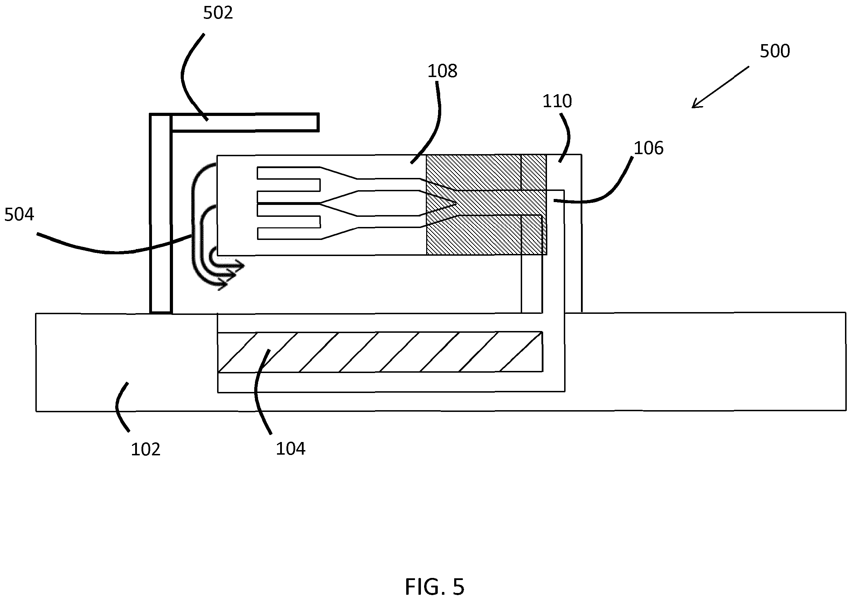

FIG. 5 shows a piezoelectric fan 500 with a heat pipe 106 according to another example embodiment. The piezoelectric fan 500 includes an air vane 502 attached to the electronic device 102. As the free end of the beam 108 oscillates mechanically, the airflow 504 is generated. The air vane 502 is constructed and arranged to direct the generated airflow 504 over the surface of the electronic component 104 creating a forced convection system.

The surface of the electronic component 104 has a temperature that may be higher than the temperature of the generated airflow 504. The generated airflow 504 is blown over the surface of the electronic component 104 and displaces air that has been heated by the heat generated by the electronic component 104. Therefore, the temperature of air near the surface of the electronic component 104 is cooled. As a result, heat may be dissipated from the surface of the electronic component 104 faster than a system that relies on natural convection system.

The air vane 502 may have an inverted 'L' shape. However, it should be understood that this is a non-limiting example and the configuration of the air vane 502 can be any shape such that the generated airflow is directed over the surface of the electronic component 104.

The beam 108 in FIG. 1, and FIGS. 3 - 5 is shown arranged perpendicular to the surface of the electronic device 102. However, it should be understood that the beam 108 may be placed co-directional to the surface of the electronic device 102.

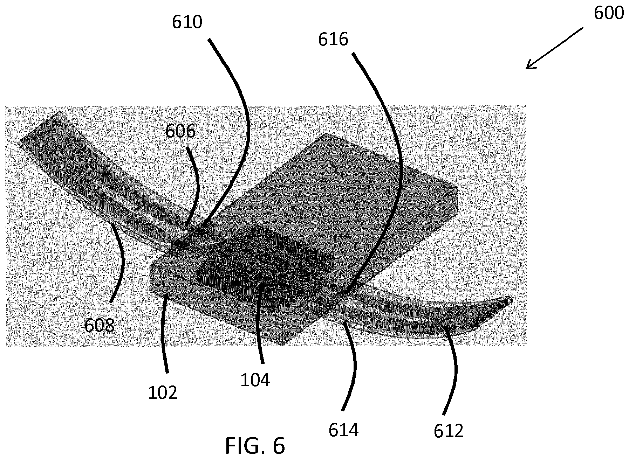

FIG. 6, which is outside the scope of the claims, shows a flying apparatus 600, for instance a drone with a plurality of heat pipes. The vehicle 600 comprises a first flexible cantilever beam 608 attached at one end of a support 610. The support 610 may be an integral part of the apparatus 600 or the electronic device 102 or it maybe a separate component. The opposite end of the first beam 608 is able to move freely. A first end of a first piezoelectric actuator is attached to the first post 610 and a second, opposite end of the first piezoelectric actuator is attached to the first beam 608. The first post is fixed to a first side of the electric device 102, which includes an electronic component 104. A first heat pipe 606 runs along the surface of the electronic component 104 through the first post 610 and through the first beam 608.

The apparatus 600 further comprises a second flexible cantilever beam 614 attached at one end of a second support 616. The second support 616 may be an integral part of the apparatus 600 or the electronic device 102 or it may be a separate component. The opposite end of the second beam 614 is able to move freely. A first end of a second piezoelectric actuator is attached to the second support 616 and a second, opposite end of the second piezoelectric actuator is attached to the second beam 608. The first post is fixed to a second side, opposite the first side of the electric device 102. A second heat pipe 612 runs along the surface of the electronic component 104 through the second post 614 and through the second beam 612.

Each beam 608 and 614 extends outwardly from the electronic device in opposite directions to form a pair of wings. An Alternating Current (AC) voltage is applied to each piezoelectric actuator which causes each piezoelectric actuator to expand and contract. As each piezoelectric actuator expands and contracts the free end of each of the beams 608 and 614 oscillates mechanically. The oscillations generate an airflow at the free end of each beam 608 and 614. The same AC voltage is applied to each piezoelectric actuator which causes the free end of each beam 608 and 614 to oscillate at the same phase and frequency. The oscillations generate a propelling force which propels the electronic device in a forward direction.

The term electronic component is also intended to cover electrical components, and may include passive and active components including microprocessors, power supplies and radio transceivers, to give some examples.

Instead of a piezoelectric actuator being used to oscillate the beam, an electromagnetic actuator may be used. Alternatively, an electric motor may be used. For instance, a rotary electric motor may be used in tandem with a crank or other mechanism to convert rotary motion into reciprocating linear motion. Alternative mechanisms for oscillating the beam will be apparent to the skilled person.

In example embodiments, the heat pipe may be a loop-type heat pipe. In these embodiments, the heat pipe is in the form of a loop or circuit. At the evaporator region, the heat from the electronic component in operation causes the working fluid to change phase from a liquid to a gas. The gas travels along the heat pipe and condenses back to a liquid at the condenser region. The liquid then travels along the heat pipe back to the evaporator region where the process begins again. A loop-type heat pipe has the advantage of not requiring a wick internally within the heat pipe. Other types of heat pipe are known.

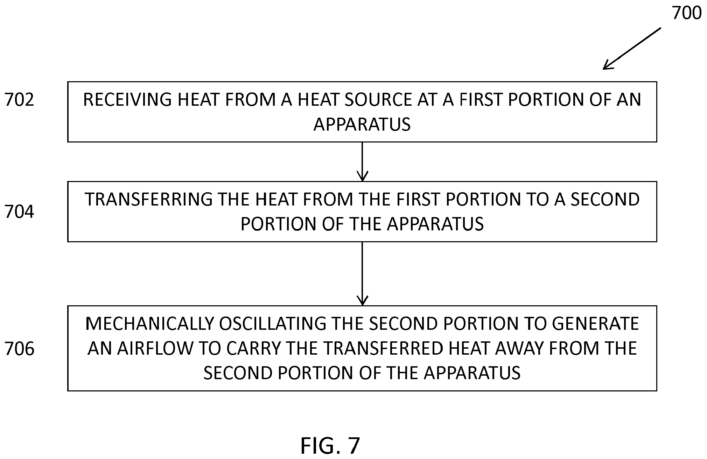

Fig. 7 is a flow diagram showing example operations of the heat transfer entity. A first operation 702 may comprise receiving heat from a heat source at a first portion. The heat (or thermal energy) is received from an electronic component that generates heat. The first portion of the heat transfer entity is located proximate to the electronic component or, alternatively, the first portion maybe in contact with a surface the electronic component.

A second operation 704 may comprise transferring the heat from the first portion to a second portion of the heat transfer entity. Heat is transferred from the first portion to the second portion because of the temperature gradient between the first portion and the second portion. In example embodiments, the first portion is at a higher temperature compared to the second portion. As a result, heat is transferred from the first portion to the second portion.

A third operation 706 may comprise mechanically oscillating the second portion to generate an airflow to carry the transferred heat away from the second portion of the apparatus. The first portion is fixed to a piezoelectric element and the second portion is free to move. An applied electric field causes oscillations in the piezoelectric element which causes the second portion to oscillate. The oscillation at the second portion generates the airflow.

It will be appreciated that some operations maybe modified or omitted. Further operations may be added.

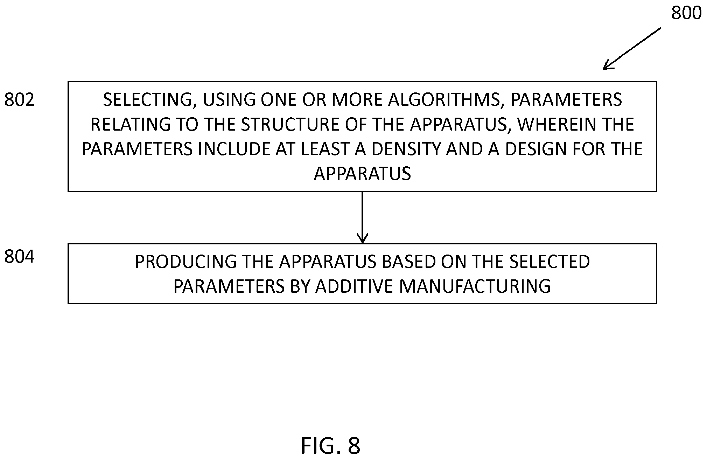

Fig. 8 is a flow diagram showing example operations for manufacturing the apparatus.

A first operation 802 may comprise selecting, using one or more algorithms, parameters relating to the structure of the apparatus, wherein the parameters include at least a density and a design for the apparatus.

A second operation 804 may comprise producing the apparatus based on the selected parameters by additive manufacturing.

In example embodiments, the apparatus includes a heat pipe that may be formed from any suitable material which is made by additive manufacturing (or 3D printing) processes. Examples of such materials may be metals such as aluminium or non-metal materials such as conductive plastic or a combination thereof. Thermal parameters may be made by one or more algorithms. Once the parameters have been determined, the module may be manufactured based on the selected parameters by additive manufacturing.

The beam may be made using 3D printing and formed of 3D printed material. The heat pipe that runs through the beam may be formed by a cavity formed using the 3D printing process, i.e. the beam is 3D printed with cavities that form the heat pipe. In this case, the beam may be 3D printed in a plastics material, or alternatively in metal. In embodiments in which the heat pipe 106 is provided with a wick, the wick may be 3D printed along with the heat pipe 106 or it may be fitted into the cavities of the heat pipe after the heat pipe has been 3D printed. The walls of the cavities of the heat pipe 106 may be formed by the material of the beam. Alternatively, the heat pipe 106 may be formed in one material and the remainder of the beam may be formed in another material. In these embodiments, the heat pipe 106 and the remainder of the beam may be 3D printed together, or the heat pipe 106 may be printed first and the remainder of the beam then printed around the heat pipe.

The thickness of the beam is typically about 300 to 1000 micrometres. It should be understood that any suitable thickness could be used instead.

The post may be made using 3D printing and formed of a 3D printed material. The heat pipe that runs through the post may be formed of a cavity formed using the 3D printing process, i.e. the post is 3D printed with the cavity present. The beam and the post may be formed in a single continuous 3D printing process or may be formed separately and coupled together with, for example, an adhesive.

The electronic device 102 may be made using 3D printing and formed of a 3D printed material. The heat pipe 106 that runs the electronic device may be formed by a cavity using a 3D printing process. The post and the electronic device may be formed in a single continuous 3D printing process or may be formed separately and coupled together with, for example, an adhesive. The heat pipe 106 in the electronic device may be manufactured to fit around the electronic component such that the heat pipe is in contact with the electronic component.

In example embodiments, the heat pipe 106 is formed of a metal. The metal may for instance be copper, which has particularly good heat conduction properties. Alternatively, any suitable metal may be used, with aluminium being one example.

Although embodiments of the present invention have been described in the preceding paragraphs with reference to various examples, it should be appreciated that modifications to the examples given can be made without departing from the scope of the appended claims.

## Claims

1. Apparatus (100) comprising:
means comprising a heat pipe (106) which comprises a fluid which changes phase from a liquid in a first portion thereof, due to heating, into a gas which travels to a second portion thereof, the heat pipe being configured for receiving heat from a heat source (104) at the first portion thereof and for transferring heat from the first portion to the second portion thereof, **characterized in that** the second portion is carried by a flexible substrate (108) positioned over the heat source, the flexible substrate having a free-end configured to mechanically oscillate for generating an airflow to carry the transferred heat away from the second portion whereby the gas condenses back into a liquid.

2. The apparatus of claim 1, wherein the flexible substrate comprises or is coupled to a piezoelectric oscillator.

3. The apparatus of claim 1 or claim 2, wherein the flexible substrate is a cantilever blade or beam.

4. The apparatus of any preceding claim, wherein the flexible substrate is a substantially planar blade or beam.

5. The apparatus of any preceding claim, wherein the second portion of the heat pipe comprises a plurality of branches.

6. The apparatus of any preceding claim, further comprising one or more electronic components in contact with, or proximate to, the first portion.

7. The apparatus of any preceding claim, wherein the first portion of the heat pipe runs on opposite sides of the heat source.

8. A method (600) comprising:
receiving (602) heat from a heat source at a first portion of a heat pipe;
transferring (604) the heat from the first portion to a second portion of the heat pipe carried by a flexible substrate (108) over the heat source, the flexible substrate having a free-end;
mechanically oscillating (606) the substrate free-end to generate an airflow to carry the transferred heat away from the second portion of the heat pipe.

## Patentansprüche

1. Vorrichtung (100), die Folgendes umfasst:
Mittel, die ein Wärmerohr (106) umfassen, das ein Fluid umfasst, das eine Phase von einer Flüssigkeit in einem ersten Abschnitt davon durch Erwärmen in ein Gas ändert, das zu einem zweiten Abschnitt davon geleitet wird, wobei das Wärmerohr dazu ausgelegt ist, am ersten Abschnitt davon Wärme von einer Wärmequelle (104) zu empfangen und Wärme vom ersten Abschnitt zum zweiten Abschnitt davon zu übertragen,
**dadurch gekennzeichnet, dass** der zweite Abschnitt von einem flexiblen Substrat (108), das über der Wärmequelle positioniert ist, getragen wird, wobei das flexible Substrat ein freies Ende aufweist, das dazu ausgelegt ist, zum Erzeugen eines Luftstroms mechanisch zu oszillieren, um die übertragene Wärme vom zweiten Abschnitt weg zu tragen, wodurch das Gas wieder zu einer Flüssigkeit kondensiert.

2. Vorrichtung nach Anspruch 1, wobei das flexible Substrat einen piezoelektrischen Oszillator umfasst oder an einen solchen gekoppelt ist.

3. Vorrichtung nach Anspruch 1 oder Anspruch 2, wobei das flexible Substrat ein ausgekragtes Blatt oder ein solcher Balken ist.

4. Vorrichtung nach einem der vorhergehenden Ansprüche, wobei das flexible Substrat ein im Wesentlichen planares Blatt oder ein solcher Balken ist.

5. Vorrichtung nach einem der vorhergehenden Ansprüche, wobei der zweite Abschnitt des Wärmerohrs eine Vielzahl von Abzweigungen umfasst.

6. Vorrichtung nach einem der vorhergehenden Ansprüche, die ferner eine oder mehrere elektronische Komponenten umfasst, die mit dem ersten Abschnitt in Kontakt sind oder sich in dessen Nähe befinden.

7. Vorrichtung nach einem der vorhergehenden Ansprüche, wobei der erste Abschnitt des Wärmerohrs auf gegenüberliegenden Seiten der Wärmequelle verläuft.

8. Verfahren (600), das Folgendes umfasst:
Empfangen (602) von Wärme an einem ersten Abschnitt eines Wärmerohrs von einer Wärmequelle;
Übertragen (604) der Wärme vom ersten Abschnitt zu einem zweiten Abschnitt des Wärmerohrs, das von einem flexiblen Substrat (108) über der Wärmequelle getragen wird, wobei das flexible Substrat ein freies Ende aufweist;
mechanisches Oszillieren (606) des freien Endes des Substrats, um einen Luftstrom zu erzeugen, um die übertragene Wärme vom zweiten Abschnitt des Wärmerohrs weg zu tragen.

## Revendications

1. Appareil (100) comprenant :
des moyens comprenant un caloduc (106) qui comprend un fluide présentant un changement de phase qui passe d'un liquide dans sa première partie, en raison du chauffage, à un gaz qui se déplace vers sa seconde partie, le caloduc étant configuré pour recevoir la chaleur d'une source de chaleur (104) au niveau de sa première partie et pour transférer la chaleur de la première partie à sa seconde partie, **caractérisé en ce que** :
la seconde partie est portée par un substrat flexible (108) positionné sur la source de chaleur, le substrat flexible ayant une extrémité libre configurée pour osciller mécaniquement afin de générer un flux d'air pour transporter la chaleur transférée à l'opposé de la seconde partie, moyennant quoi le gaz se condense à nouveau en liquide.

2. Appareil selon la revendication 1, dans lequel le substrat flexible comprend ou est couplé à un oscillateur piézoélectrique.

3. Appareil selon la revendication 1 ou la revendication 2, dans lequel le substrat flexible est une lame ou poutre en porte-à-faux.

4. Appareil selon l'une quelconque des revendications précédentes, dans lequel le substrat flexible est une lame ou poutre sensiblement planaire.

5. Appareil selon l'une quelconque des revendications précédentes, dans lequel la seconde partie du caloduc comprend une pluralité de ramifications.

6. Appareil selon l'une quelconque des revendications précédentes, comprenant en outre un ou plusieurs composants électriques en contact avec ou à proximité de la première partie.

7. Appareil selon l'une quelconque des revendications précédentes, dans lequel la première partie du caloduc s'étend sur les côtés opposés de la source de chaleur.

8. Procédé (600) comprenant les étapes consistant à :
recevoir (602) la chaleur d'une source de chaleur au niveau d'une première partie d'un caloduc ;
transférer (604) la chaleur de la première partie à une seconde partie du caloduc portée par un substrat flexible (108) sur la source de chaleur, le substrat flexible ayant une extrémité libre ;
faire osciller (606) mécaniquement l'extrémité libre du substrat pour générer un flux d'air afin d'évacuer la chaleur transférée à l'opposé de la seconde partie du caloduc.
